# EUROPEAN PATENT APPLICATION

(11) **EP 3 564 752 A1**
(43) Date of publication of application: **06.11.2019**
(21) Application number: 17888261.9
(22) Date of filing: 11.12.2017
(51) Int. Cl.: G03F 7/038

(54) **RADIATION SENSITIVE COMPOSITION, PATTERN FORMING METHOD AND METAL OXIDE**

(30) Priority: 28.12.2016 JP 2016255425
(71) Applicant: JSR Corporation, Minato-ku Tokyo 105-8640 (JP)
(72) Inventor: MINEGISHI Shinya, Tokyo 105-8640 (JP); SHIRATANI Motohiro, Tokyo 105-8640 (JP); ASANO Yusuke, Tokyo 105-8640 (JP); NAKAGAWA Hisashi, Tokyo 105-8640 (JP); NARUOKA Takehiko, Tokyo 105-8640 (JP)
(74) Representative: TBK
(86) International application number: PCT/JP2017/044367
(87) International publication number: WO 2018/123537

(57) **Abstract**

Provided is a radiation-sensitive composition superior in sensitivity. A radiation-sensitive composition incudes a metal oxide having a structural unit represented by formula (1), and a solvent. In the formula (1), M represents germanium, tin or lead; R¹ represents a monovalent organic group having no greater than 30 carbon atoms which includes at least one of an electron attractive group and an unsaturated bond-containing group, and bonds to M via a carbon atom. The monovalent organic group represented by R¹ preferably includes the unsaturated bond-containing group, and the unsaturated bond-containing group is preferably at least one of an aromatic group and an ethylenic double bond-containing group. The monovalent organic group represented by R¹ preferably includes the electron attractive group, and the electron attractive group is preferably at least one of a cyano group, a nitro group, a halogenated alkyl group, -COO-, and a cationic group. The content of the metal oxide in terms of solid content equivalent is preferably no less than 50% by mass.

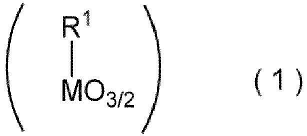

## Description

### [Technical Field]

The present invention relates to a radiation-sensitive composition, a pattern-forming method and a metal oxide.

### [Background Art]

A radiation-sensitive composition for use in microfabrication by lithography generates an acid at a light-exposed region upon an exposure with an electromagnetic wave such as a far ultraviolet ray (ArF excimer laser beam, KrF excimer laser beam, etc.) or an extreme ultraviolet ray (EUV: Extreme Ultraviolet), a charged particle ray such as an electron beam. A chemical reaction in which the acid serves as a catalyst causes the difference in rates of dissolution in a developer solution, between light-exposed regions and light-unexposed regions to enable a resist pattern to be formed on a substrate.

Such radiation-sensitive compositions are demanded to have improved resist performances along with miniaturization in processing techniques. To meet such demands, types, molecular structures and the like of polymers, acid generating agents and other components which may be used in the compositions have been investigated, and combinations thereof have been further investigated in detail (see, Japanese Unexamined Patent Application, Publication Nos. H11-125907, H8-146610 and 2000-298347).

### [Prior Art Documents]

### [Patent Documents]

Patent Document 1: Japanese Unexamined Patent Application, Publication No. H11-125907
Patent Document 2: Japanese Unexamined Patent Application, Publication No. H8-146610
Patent Document 3: Japanese Unexamined Patent Application, Publication No. 2000-298347

### [SUMMARY OF THE INVENTION]

### [Problems to be Solved by the Invention]

At present, miniaturization of patterns has proceeded to a level for line widths of no greater than 40 nm, whereby radiation-sensitive compositions are needed to have various resist performances being further improved, and to be capable of achieving high sensitivity also in cases of exposure with an electron beam, EUV and the like, in particular. However, the conventional radiation-sensitive compositions have not satisfied the needs.

The present invention was made in view of the foregoing circumstances, and an object of the invention is to provide a radiation-sensitive composition superior in sensitivity.

### [Means for Solving the Problems]

According to one aspect of the invention made for solving the aforementioned problems, a radiation-sensitive composition contains a metal oxide having a structural unit represented by the following formula (1), and a solvent, 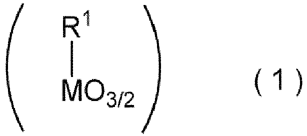 wherein, in the formula (1), M represents germanium, tin or lead; R¹ represents a monovalent organic group having no greater than 30 carbon atoms which includes at least one of an electron attractive group and an unsaturated bond-containing group, and bonds to M via a carbon atom.

According to other aspect of the invention made for solving the aforementioned problems, a pattern-forming method includes: applying the radiation-sensitive composition of the one aspect of the invention directly or indirectly on a substrate to provide a film; exposing the film; and developing the film exposed.

According to still other aspect of the invention made for solving the aforementioned problems, a metal oxide has a structural unit represented by the following formula (1): 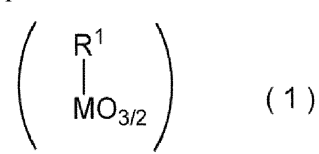 wherein, in the formula (1), M represents germanium, tin or lead; R¹ represents a monovalent organic group having no greater than 30 carbon atoms which includes at least one of an electron attractive group and an unsaturated bond-containing group, and bonds to M via a carbon atom.

The term "metal oxide" as referred to herein means a compound that includes at least a metal atom and an oxygen atom. The term "organic group" as referred to herein means a group having at least one carbon atom.

### [Effects of the Invention]

The radiation-sensitive composition and pattern-forming method according to the aspects of the present invention enable a pattern to be formed with superior sensitivity being achieved. The metal oxide according to the still other aspect of the present invention can be suitably used as a source material of the radiation-sensitive composition of the one aspect of the invention. Therefore, these can be suitably used in manufacture of semiconductor devices in which further progress of miniaturization is expected in the future.

### [Description of Embodiments]

### Radiation-Sensitive Composition

The radiation-sensitive composition of one embodiment of the invention contains: a metal oxide (hereinafter, may be also referred to as "(A) metal oxide" or "metal oxide (A)") having a structural unit represented by the following formula (1) (hereinafter, may be also referred to as "structural unit (I)"); and a solvent (hereinafter, may be also referred to as "(B) solvent" or "solvent (B)"). The radiation-sensitive composition may further contain optional component(s) such as a radiation-sensitive base generator (hereinafter, may be also referred to as "(C) base generator" or "base generator (C)"), and (D) a surfactant described later, within a range not leading to impairment of the effects of the present invention. The radiation-sensitive composition can be suitably used for a pattern-forming method in which an exposure with an extreme ultraviolet ray or an electron beam is conducted. Hereinafter, each component will be described.

### (A) Metal Oxide

The metal oxide (A) has the structural unit (I). The metal oxide (A) may further have an arbitrary structural unit such as structural units (II) to (IV) as described later. In the radiation-sensitive composition, the metal oxide (A) may be used either alone of one type, or in combination of two or more types thereof. The metal oxide (A) serves as a principal component of the film formed from the radiation-sensitive composition. The term "principal component" as referred to herein means a component which is of the highest content, for example, a component the content of which is no less than 50% by mass.

Due to having the structural unit (I) in the metal oxide (A), the radiation-sensitive composition is superior in sensitivity. Although not necessarily clarified and without wishing to be bound by any theory, the reason for achieving the effects described above due to the radiation-sensitive composition having the aforementioned constitution is inferred as in the following, for example. Specifically, when the metal oxide (A) is affected by exposure light such as EUV or an electron beam, radical formation (elimination of the group represented by R¹) is believed to occur in the following formula (1) through cleavage of a metal-carbon covalent bond between the metal atom represented by M and the group represented by R¹. Thus, it is considered that at a light-exposed region of the film formed from the radiation-sensitive composition, metal oxide (A) molecules that form radicals are bonded to each other to increase in the molecular weight, leading to a change in solubility in a developer solution, whereby pattern formation is enabled. Here, it is believed that the metal-carbon covalent bond included in the structural unit (I) is appropriately stable due to being a bond between a carbon atom and germanium, tin, or lead belonging to an identical group (group 14) with the carbon atom in periodic table, and that ionization is less likely to occur due to comparatively poor polarization. Furthermore, due to including the unsaturated bond-containing group and/or electron attractive group, the group represented by R¹ included in the structural unit (I) is considered to be comparatively stable also in radical formation. Consequently, it is considered that the radiation-sensitive composition allows an increase in molecular weight of the metal oxide (A) to be inhibited in an unexposed state, whereas promoting an increase in the molecular weight is enabled upon exposure, and as a result, superior sensitivity can be achieved with sufficient stability as a radiation-sensitive composition being maintained.

### Structural Unit (I)

The structural unit (I) is represented by the following formula (1).

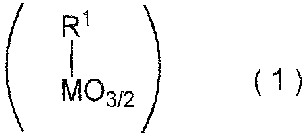

In the above formula (1), M represents germanium, tin or lead; R¹ represents a monovalent organic group having no greater than 30 carbon atoms which includes at least one of an electron attractive group and an unsaturated bond-containing group, and bonds to M via a carbon atom.

It is to be noted that a group having both an unsaturated bond and an electron attractivity is herein deemed to be the unsaturated bond-containing group.

It is preferred that M represents tin.

The monovalent organic group represented by R¹ may include a plurality of groups each having an unsaturated bond, or may include a plurality of electron attractive groups.

The upper limit of the number of carbon atoms in the monovalent organic group represented by R¹ is preferably 20, more preferably 10, and still more preferably 5.

Examples of the unsaturated bond-containing group in R¹ include an aromatic group, an ethylenic double bond-containing group, an acetylenic triple bond-containing group and the like.

The term "aromatic group" as referred to herein means a group that includes one or a plurality of aromatic rings, and examples thereof include:
aryl groups such as a phenyl group, a tolyl group, a xylyl group, a naphthyl group and an anthryl group;
substituted aryl groups obtained by substituting a part or all of hydrogen atoms included in the aryl group with a hetero atom-containing group;
arylene groups having 6 to 30 carbon atoms such as a phenylene group, a tolylene group, a xylylene group, a naphthylene group and an anthrylene group;
substituted arylene groups obtained by substituting a part or all of hydrogen atoms included in the arylene group with a hetero atom-containing group; and the like.

Examples of the hetero atom-containing group that substitutes for the aryl group or the arylene group include halogen atoms such as a fluorine atom, a chlorine atom, a bromine atom and an iodine atom, a hydroxy group, a carboxy group, a cyano group, an amino group, a sulfanyl group (-SH), and the like.

Examples of the ethylenic double bond-containing group include:
alkenyl groups having 2 to 30 carbon atoms such as an ethenyl group, a propenyl group and a butenyl group;
alkenediyl groups having 2 to 30 carbon atoms such as an ethenediyl group, a propenediyl group and a butenediyl group;
alicyclic unsaturated hydrocarbon groups having 3 to 30 carbon atoms and having a double bond, such as a cyclopropenyl group, a cyclopentenyl group, a cyclohexenyl group and a norbornenyl group; and the like.

The "hydrocarbon group" herein may include a chain hydrocarbon group, an alicyclic hydrocarbon group and an aromatic hydrocarbon group. This "hydrocarbon group" may be a saturated hydrocarbon group or an unsaturated hydrocarbon group. The "chain hydrocarbon group" as referred to herein means a hydrocarbon group not including a ring structure but comprising only a chain structure, and both a straight chain hydrocarbon group and a branched hydrocarbon group may be involved. The "alicyclic hydrocarbon group" as referred to herein means a hydrocarbon group not including an aromatic ring structure but comprising only an alicyclic structure as the ring structure, and both a monocyclic alicyclic hydrocarbon group and a polycyclic alicyclic hydrocarbon group may be involved. However, the alicyclic hydrocarbon group does not need to be constituted with only the alicyclic structure, and a part thereof may include a chain structure. The "aromatic hydrocarbon group" as referred to herein means a hydrocarbon group including an aromatic ring structure as the ring structure. However, the aromatic hydrocarbon group does not need to be constituted with only the aromatic ring structure, and a part thereof may include a chain structure and/or an alicyclic structure.

Examples of the acetylenic triple bond-containing group include:
alkynyl groups having 2 to 30 carbon atoms such as an ethynyl group, a propynyl group and a butynyl group;
alkynediyl groups having 2 to 30 carbon atoms such as an ethynediyl group, a propynediyl group and a butynediyl group; and the like.

The unsaturated bond-containing group in R¹ is preferably an aromatic group or an ethylenic double bond-containing group, more preferably an aryl group or an alkenyl group, and still more preferably a phenyl group or an ethenyl group.

Examples of the electron attractive group included in R¹ include a cyano group, a nitro group, a halogenated alkyl group, -COO-, a cationic group, an alkoxy group, -SO₂-, and the like.

The upper limit of the number of carbon atoms of the halogenated alkyl group, the cationic group and the alkoxy group is not particularly limited, but preferably 30, more preferably 10, and still more preferably 3.

Examples of the halogenated alkyl group include a fluorinated alkyl group, a chlorinated alkyl group, a brominated alkyl group, and the like. Of these, a fluorinated alkyl group is preferred, a perfluoroalkyl group is more preferred, and a trifluoromethyl group is still more preferred.

Examples of the cationic group include an ammonium group, a phosphonium group, a sulfonium group, an iodonium group, a diazonium group, and the like.

Examples of the alkoxy group include a methoxy group, an ethoxy group, a n-propoxy group, an i-propoxy group, and the like.

The electron attractive group is preferably a cyano group, a nitro group, a halogenated alkyl group, -COO- or a cationic group.

The structural unit (I) is preferably a structural unit (I-1) represented by the following formula (1-1). 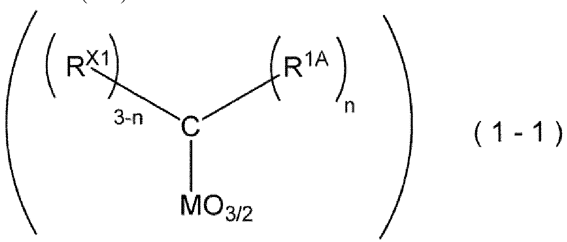 In the above formula (1-1), M is as defined in the above formula (1); R^{1A} represents: a first substituent that is a monovalent organic group having 2 to 29 carbon atoms which includes an unsaturated bond-containing group, and bonds to the carbon atom bonding to M via one of carbon atoms constituting the unsaturated bond; a second substituent that is a monovalent organic group having 1 to 29 carbon atoms which includes a divalent electron attractive group, and bonds to the carbon atom bonding to M via the divalent electron attractive group; or a monovalent electron attractive group; R^{X1} represents a hydrogen atom, or an alkyl group having 1 to 5 carbon atoms; and n is an integer of 1 to 3, wherein in a case in which there exist a plurality of R^{1A}s, the plurality of R^{1A}s are identical or different, and in a case in which there exist a plurality of R^{X1}s, the plurality of R^{X1}s are identical or different.

In the above formula (1-1), the alkyl group having 1 to 5 carbon atoms which may be represented by R^{X1} is exemplified by alkyl groups having 1 to 5 carbon atoms such as a methyl group, an ethyl group, a propyl group, an i-propyl group, a n-butyl group, a sec-butyl group, an isobutyl group and a tert-butyl group. In particular, a hydrogen atom, a methyl group and an ethyl group are preferred.

Due to having the structural unit (I-1) as the structural unit (I), i.e., due to bonding of the carbon atom constituting the unsaturated bond or the electron attractive group to M via the carbon atom to which R^{X1} bonds, a more improvement of the stability in radical formation by a substituent represented by -C(R^{X1})₃₋ₙ-(R^{1A})ₙ is enabled. As a result, radical formation from the metal oxide (A) can be more promoted, thereby enabling the sensitivity of the radiation-sensitive composition to be more improved.

It is to be noted that the first substituent may include a group having a plurality of unsaturated bond, or may include one or a plurality of electron attractive groups. The second substituent may include a plurality of electron attractive groups, or may include a group having one or a plurality of unsaturated bonds.

Examples of the first substituent which may be represented by R^{1A} include groups represented by the following formulae (A-1) to (A-3), and the like.

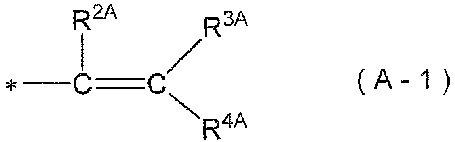

* -C≡C-R^{5A} (A - 2)

* - Ar (A-3)

In the above formulae (A-1) to (A-3), * denotes a binding site to the carbon atom bonding to M.

In the above formula (A-1), R^{2A} to R^{4A} each independently represent a hydrogen atom or a monovalent organic group having 1 to 27 carbon atoms, or two or more of R^{2A} to R^{4A} taken together represent a ring structure having 3 to 30 ring atoms together with the carbon atom or the carbon chain to which the two or more of R^{2A} to R^{4A} bond.

In the above formula (A-2), R^{5A} represents a monovalent organic group having 1 to 27 carbon atoms.

In the above formula (A-3), Ar represents a substituted or unsubstituted aryl group having 6 to 29 carbon atoms.

The number of "ring atom" as referred to herein means the number of atoms constituting the ring in an aromatic ring structure, an aromatic heterocyclic structure, an alicyclic structure or an aliphatic heterocyclic structure, and in the case of a polycyclic ring structure, the number of "ring atoms" means the number of atoms constituting the polycycle.

The number of carbon atoms of the monovalent organic group which may be represented by R^{2A} to R^{5A} is preferably 1 to 20, more preferably 1 to 10, and still more preferably 1 to 3.

The monovalent organic group which may be represented by R^{2A} to R^{5A} is exemplified by: a monovalent hydrocarbon group having 1 to 27 carbon atoms; a group (α) that includes a divalent hetero atom-containing group between two adjacent carbon atoms or at the end of the atomic bonding side of the monovalent hydrocarbon group having 1 to 27 carbon atoms; a group obtained from the monovalent hydrocarbon group having 1 to 27 carbon atoms, or the group (α) by substituting a part or all of hydrogen atoms included therein with a monovalent hetero atom-containing group; and the like.

The monovalent hydrocarbon group having 1 to 27 carbon atoms is exemplified by a monovalent chain hydrocarbon group having 1 to 27 carbon atoms, a monovalent alicyclic hydrocarbon group having 3 to 27 carbon atoms, a monovalent aromatic hydrocarbon group having 6 to 27 carbon atoms, and the like.

Examples of the monovalent chain hydrocarbon group having 1 to 27 carbon atoms include:
alkyl groups such as a methyl group, an ethyl group, a n-propyl group and an i-propyl group;
alkenyl groups such as an ethenyl group, a propenyl group and a butenyl group;
alkynyl groups such as an ethynyl group, a propynyl group and a butynyl group; and the like.

Examples of the monovalent alicyclic hydrocarbon group having 3 to 27 carbon atoms include:
monocyclic alicyclic saturated hydrocarbon groups such as a cyclopentyl group and a cyclohexyl group;
monocyclic alicyclic unsaturated hydrocarbon groups such as a cyclopentenyl group and a cyclohexenyl group;
polycyclic alicyclic saturated hydrocarbon groups such as a norbornyl group, an adamantyl group and a tricyclodecyl group;
polycyclic alicyclic unsaturated hydrocarbon groups such as norbornenyl group and a tricyclodecenyl group; and the like.

Examples of the monovalent aromatic hydrocarbon group having 6 to 27 carbon atoms include:
aryl groups such as a phenyl group, a tolyl group, a xylyl group, a naphthyl group and an anthryl group;
aralkyl groups such as a benzyl group, a phenethyl group, a naphthylmethyl group and an anthryl methyl group; and the like.

Examples of the hetero atom constituting the monovalent hetero atom-containing group or the divalent hetero atom-containing group include an oxygen atom, a nitrogen atom, a sulfur atom, a phosphorus atom, a halogen atom, and the like. Examples of the halogen atom include a fluorine atom, a chlorine atom, a bromine atom, an iodine atom, and the like.

The divalent hetero atom-containing group is exemplified by -O-, -CO-, -S-, -SO₂-, - CS-, -NR'-, a group obtained by combining two or more of these, and the like, wherein R' represents a hydrogen atom or a monovalent hydrocarbon group.

Examples of the monovalent hetero atom-containing group include halogen atoms such as a fluorine atom, a chlorine atom, a bromine atom and an iodine atom, a hydroxy group, a carboxy group, a cyano group, an amino group, a sulfanyl group (-SH), and the like.

Examples of the ring structure having 3 to 30 ring atoms which may be taken together represented by two or more of R^{2A} to R^{4A} together with the carbon atom or the carbon chain to which the two or more of R^{2A} to R^{4A} bond include alicyclic structures such as a cycloalkane structure, as well as aliphatic heterocyclic structures such as a lactone ring structure, and the like.

R^{2A} to R^{5A} each represent preferably a hydrogen atom or a monovalent hydrocarbon group, more preferably a hydrogen atom or a monovalent chain hydrocarbon group, and still more preferably a hydrogen atom or an alkyl group, and particularly preferably a hydrogen atom.

Examples of the aryl group represented by Ar and a substituent therefor include similar groups to the aryl groups exemplified in the above formula (1), and the like.

The number of carbon atoms of the aryl group represented by Ar is preferably 6 to 20, and more preferably 6 to 10.

The aryl group represented by Ar is preferably a phenyl group.

Examples of the second substituent which may be represented by R^{1A} include groups represented by the following formula (A-4), and the like.

* -W-R^{6A} (A-4)

In the above formula (A-4), W represents a divalent electron attractive group; and R^{6A} represents an organic group having 1 to 29 carbon atoms.

Examples of the divalent electron attractive group represented by W include -COO-, -CH₂COO-, -SO₂-, and the like.

Examples of the monovalent organic group represented by R^{6A} include similar groups to the monovalent organic groups exemplified for R^{2A} to R^{5A}, and the like. The number of carbon atoms of the monovalent organic group represented by R^{6A} is preferably 1 to 20, more preferably 1 to 10, and still more preferably 1 to 3.

The monovalent organic group represented by R^{6A} is preferably a monovalent hydrocarbon group, more preferably a monovalent chain hydrocarbon group, still more preferably an alkyl group, and particularly preferably a methyl group.

The lower limit of the proportion of the structural unit (I) contained with respect to the total structural units constituting the metal oxide (A) is preferably 20 mol%, more preferably 50 mol%, and still more preferably 70 mol%. Meanwhile, the upper limit of the proportion of the structural unit (I) contained is preferably 99 mol%, and more preferably 90 mol%. The proportion of the structural unit (I) contained falling within the above range enables the sensitivity of the radiation-sensitive composition to be more improved.

Examples of the monovalent electron attractive group which may be represented by R^{1A} include monovalent groups among those exemplified as the electron attractive group which may be represented by R¹ in the above formula (1), i.e., a cyano group, a nitro group, a halogenated alkyl group, a cationic group, an alkoxy group, and the like.

In the above formula (1-1), n is preferably 1 or 2, and more preferably 1.

Examples of the structural unit (I) include structural units represented by the following formulae, and the like.

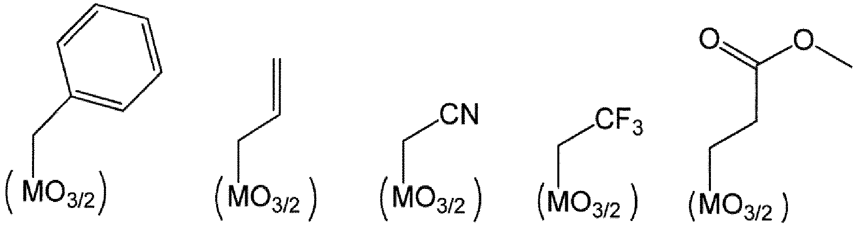

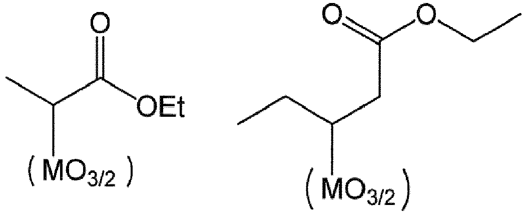

In the above formula, M is as defined in the above formula (1).

### Structural Unit (II)

The metal oxide (A) may also have a structural unit (II) represented by the following formula (2).

(MO_{4/2}) (2)

In the above formula (2), M is as defined in the above formula (1).

In a case in which the metal oxide (A) has the structural unit (II), the lower limit of the proportion of the structural unit (II) contained with respect to the total structural units constituting the metal oxide (A) is preferably 1 mol%, more preferably 3 mol%, and still more preferably 5 mol%. Meanwhile, the upper limit of the proportion of the structural unit (II) contained is preferably 50 mol%, and more preferably 30 mol%. The proportion of the structural unit (II) contained falling within the above range enables the sensitivity of the radiation-sensitive composition to be more improved.

### Structural Unit (III)

The metal oxide (A) may also have a structural unit (III) represented by the following formula (3). 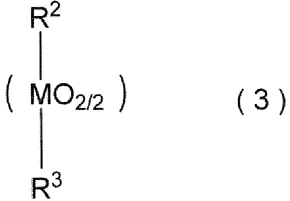 In the above formula (3), M is as defined in the above formula (1); R² and R³ each independently represent a monovalent organic group having 1 to 30 carbon atoms that bonds to M via a carbon atom.

Examples of the monovalent organic group represented by R² or R³ include groups having a carbon atom at the end of the atomic bonding side, among the organic groups exemplified in connection with R^{2A} to R^{5A} in the above formulae (A-1) to (A-2). The monovalent organic group represented by R² or R³ is preferably a group similar to the group represented by R¹ in the above formula (1), and more preferably the group represented by -C(R^{X1})₃₋ₙ-(R^{1A})ₙ in the above formula (1-1).

Examples of the structural unit (III) include structural units represented by the following formulae, and the like.

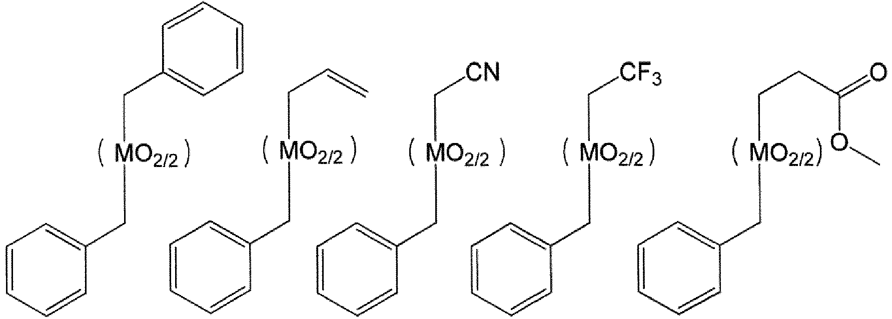

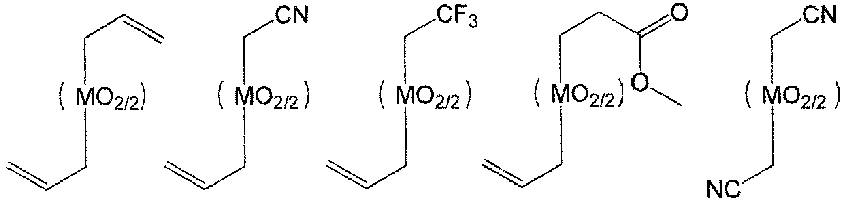

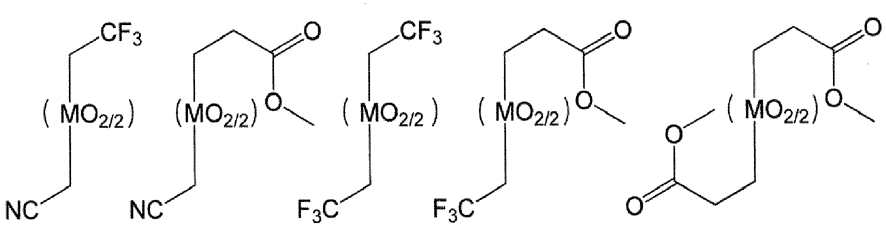

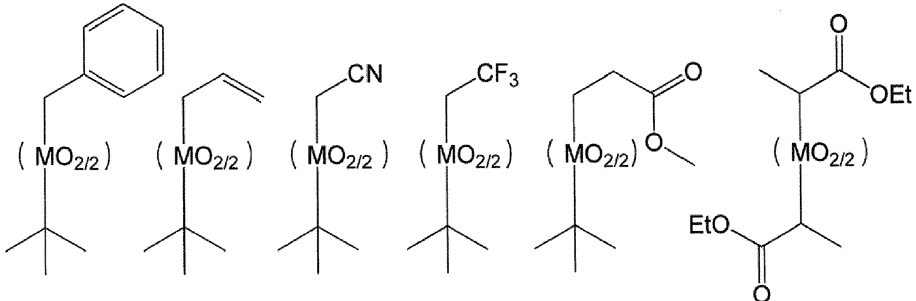

In the above formulae, M is as defined in the above formula (1).

In a case in which the metal oxide (A) has the structural unit (III), the lower limit of the proportion of the structural unit (III) contained with respect to the total structural units constituting the metal oxide (A) is preferably 1 mol%, more preferably 3 mol%, and still more preferably 5 mol%. Meanwhile, the upper limit of the proportion of the structural unit (III) contained is preferably 50 mol%, and more preferably 30 mol%. The proportion of the structural unit (III) contained falling within the above range enables the sensitivity of the radiation-sensitive composition to be more improved.

### Structural Unit (IV)

The metal oxide (A) may also have a structural unit (IV) represented by the following formula (4). 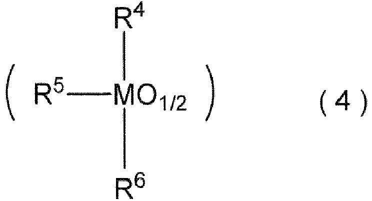 In the above formula (4), M is as defined in the above formula (1); R⁴ to R⁶ each independently represent a monovalent organic group having 1 to 30 carbon atoms that bonds to M via a carbon atom.

The monovalent organic group represented by R⁴ to R⁶ may be exemplified by groups similar to the organic groups exemplified in the above formula (3). The monovalent organic group represented by R⁴ to R⁶ may be exemplified by groups similar to the groups which may be represented by R¹ in the above formula (1).

The lower limit of the number of carbon atoms of the monovalent organic group represented by R⁴ to R⁶ is preferably 2, and more preferably 3. Meanwhile, the upper limit of the number of carbon atoms is preferably 10, and more preferably 5.

The monovalent organic group represented by R⁴ to R⁶ is preferably a monovalent hydrocarbon group, more preferably a monovalent chain hydrocarbon group, and still more preferably an alkyl group.

Examples of the structural unit (IV) include a tributyltin oxide structure represented by the following formula, and the like. 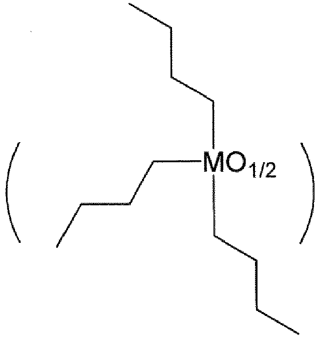 In the above formulae, M is as defined in the above formula (1).

In a case in which the metal oxide (A) has the structural unit (IV), the lower limit of the proportion of the structural unit (IV) contained with respect to the total structural units constituting the metal oxide (A) is preferably 1 mol%, more preferably 3 mol%, and still more preferably 5 mol%. Meanwhile, the upper limit of the proportion of the structural unit (IV) contained is preferably 30 mol%, and more preferably 20 mol%. The proportion of the structural unit (IV) contained falling within the above range enables the sensitivity of the radiation-sensitive composition to be more improved.

The metal oxide (A) may have a structural unit other than the structural units (I) to (IV). The other structural unit is exemplified by: a structural unit represented by (R⁷-MO_{3/2}), wherein R⁷ does not correspond to the organic group represented by R¹, but represents a monovalent organic group having 1 to 30 carbon atoms which bonds to M via a carbon atom; a structural unit having a metal atom other than germanium, tin and lead; a structural unit that includes a silicon atom; and the like. The upper limit of the proportion of the other structural unit contained with respect to the total structural units constituting the metal oxide (A) is, for example, 10 mol%.

The lower limit of the weight average molecular weight (Mw) of the metal oxide (A) is preferably 700, more preferably 1,000, still more preferably 1,200, and particularly preferably 1,400. The upper limit of the Mw is preferably 20,000, more preferably 10,000, still more preferably 8,000, and particularly preferably 7,000. The Mw of the metal oxide (A) falling within the above range enables the sensitivity of the radiation-sensitive composition to be more improved.

The Mw of the metal oxide (A) herein is a value determined by using gel permeation chromatography (GPC) under the following conditions.

GPC columns: for example, "G2000HXL" x 2, "G3000HXL" x 1 and "G4000HXL" x 1, available from Tosoh Corporation;
column temperature: 40 °C;
elution solvent: tetrahydrofuran;
flow rate: 1.0 mL/min;
sample concentration: 1.0% by mass;
amount of injected sample: 100 µL;
detector: differential refractometer; and
standard substance: mono-dispersed polystyrene

The lower limit of the content of the metal oxide in terms of solid content equivalent in the radiation-sensitive composition is preferably 50% by mass, preferably 70% by mass, and still more preferably 90% by mass. The term "solid content" as referred to herein means component(s) other than the solvent (B) in the radiation-sensitive composition.

### Synthesis Method of Metal Oxide (A)

The metal oxide (A) may be obtained by, for example: a condensation reaction using a compound (i) represented by the following formula (i); a condensate (ii) having a partial structure represented by the following formula (ii) obtained by condensation of the compound (i); or the like, in the presence of a catalyst, e.g., a quaternary ammonium salt such as hydroxylated tetramethyl ammonium. It is to be noted that the condensate (ii) may have the structural unit (I). 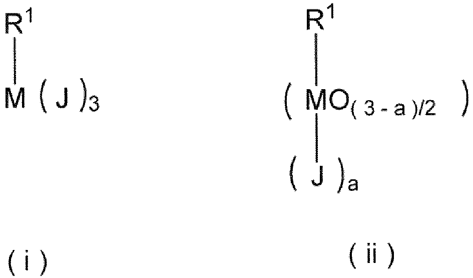 In the above formulae (i) to (ii), M and R¹ are as defined in the above formula (1); Js each independently represent a halogen atom, a hydroxy group, an ethynyl group, an ethynyl group substituted with a monovalent hydrocarbon group having 1 to 20 carbon atoms, a group represented by -OR^{B}, or a group represented by -N(R^{B})₃; and R^{B} represents a monovalent organic group, wherein in a case in which there exists a plurality of R^{B}s, the plurality of R^{B}s are identical or different.

In the above formula (ii), a is 1 or 2.

The halogen atom represented by J is exemplified by a chlorine atom, a fluorine atom, an iodine atom and the like, and a chlorine atom is preferred.

The monovalent hydrocarbon group with which the ethynyl group is substituted is exemplified by groups similar to those exemplified for R^{2A} to R^{5A}, and the like.

The monovalent organic group represented by R^{B} is preferably a monovalent hydrocarbon group, more preferably a monovalent chain hydrocarbon group, and still more preferably an alkyl group. Furthermore, the lower limit of the number of carbon atoms of the monovalent organic group represented by R^{B} is preferably 2. Meanwhile, the upper limit of the number of carbon atoms is preferably 10, and more preferably 5.

In the condensation reaction, the metal oxide (A) having the structural units (II) to (IV) may be obtained by using compounds (iii) to (v) represented by the following formulae (iii) to (v) and/or the condensate thereof together with the compound (i) and/or the condensate (ii). 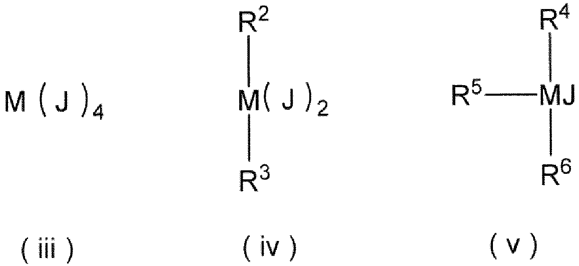 In the above formulae (iii) to (v), M and R² to R⁶ are as defined in the above formulae (2) to (4). J is as defined in the above formulae (i) to (ii).

### (B) Solvent

The solvent (B) is not particularly limited as long as it is a solvent capable of dissolving or dispersing at least the metal oxide (A), optional component(s) which may be contained as needed, and the like. It is to be noted that a solvent for the reaction used in the synthesis of the metal oxide (A) may be directly used as the solvent (B).

The solvent (B) is exemplified by organic solvents such as an alcohol solvent, an ether solvent, a ketone solvent, an amide solvent, an ester solvent, a hydrocarbon solvent and the like. As the organic solvent, an alcohol solvent is preferred.

Examples of the alcohol solvent include:
monohydric alcohol solvents such as methanol, ethanol, n-propanol, iso-propanol, n-butanol, iso-butanol, sec-butanol, tert-butanol and 4-methyl-2-pentanol;
polyhydric alcohol solvents such as ethylene glycol, 1,2-propylene glycol and 1,3-butylene glycol;
polyhydric alcohol partial ether solvents such as ethylene glycol monomethyl ether, ethylene glycol monoethyl ether, ethylene glycol monopropyl ether, propylene glycol monomethyl ether and propylene glycol monoethyl ether; and the like.

As the organic solvent, any of the solvents disclosed in paragraphs [0201] to [0206] of Japanese Unexamined Patent Application, Publication No. 2016-28274, and the like may be used.

Alternatively, the solvent (B) may be a mixed solvent containing the organic solvent as a principal component, and a small amount of water. When the solvent (B) is such a mixed solvent, hydration of the metal oxide (A) is enabled, and as a result, storage stability of the radiation-sensitive composition can be improved. Furthermore, an increase in molecular weight of the metal oxide (A) can be promoted in pattern formation.

The lower limit of the content of water in the mixed solvent is preferably 0.01% by mass, more preferably 0.1% by mass, and still more preferably 1% by mass. Meanwhile, the upper limit of the content of water is preferably 20% by mass, and more preferably 10% by mass. When the content of water is greater than the upper limit, the storage stability may be rather inferior, and uniformity of the film to be formed may be deteriorated.

The solvent (B) is preferably an organic solvent, and more preferably an alcohol solvent. The number of carbon atoms of the alcohol solvent is preferably no less than 1 and no greater than 10. The radiation-sensitive composition may contain one, or two or more types of the solvent (B).

### (C) Base Generator

The base generator (C) generates a base in a light-exposed region through a direct action by way of exposure light, as well as an action by a secondary electron generated from the metal oxide (A) resulting from the exposure light. It is considered that due to containing the base generator (C), the radiation-sensitive composition enables an increase in molecular weight of the metal oxide (A) in the light-exposed region by the base, thereby consequently enabling the sensitivity of the radiation-sensitive composition to be more improved. The base generator (C) in the radiation-sensitive composition may be contained in the form of a free compound (hereinafter, may be appropriately referred to as "(C) base generator" or "base generator (C)") or in the form incorporated as a part of the metal oxide (A), or may be in both of these forms.

The base generator (C) is exemplified by complexes of transition metals such as cobalt (hereinafter, may be also referred to as "transition metal complex"), nitrobenzyl carbamates, α,α-dimethyl-3,5-dimethoxybenzyl carbamates, acyloxyiminos, 2-nitrobenzylcyclohexyl carbamate, and the like. Specific examples of the base generator (C) include compounds disclosed in paragraphs [0272] to [0276] of Japanese Unexamined Patent Application, Publication No. 2016-200698, and the like.

In a case in which the radiation-sensitive composition contains the base generator (C), the lower limit of the content of the base generator (C) with respect to 100 parts by mass of the metal oxide (A) is preferably 0.1 parts by mass, more preferably 1 part by mass, and still more preferably 3 parts by mass. Meanwhile, the upper limit of the content is preferably 10 parts by mass, and more preferably 5 parts by mass.

### (D) Surfactant

The surfactant (D) achieves the effect of improving the coating characteristics, striation, developability and the like of the radiation-sensitive composition. The surfactant is preferably, for example, a nonionic surfactant. Specific examples of the surfactant which may be used include those disclosed in paragraph [0140] of Japanese Unexamined Patent Application, Publication No. 2009-134088, nonionic acetylene group-containing surfactants, and the like. The surfactant (D) may be used either alone of one type, or in combination of two or more types thereof.

In a case in which the radiation-sensitive composition contains the surfactant (D), the lower limit of the content of the surfactant with respect to 100 parts by mass of the metal oxide (A) is preferably 0.01 parts by mass, and more preferably 0.03 parts by mass. Meanwhile, the upper limit of the content is preferably 1 part by mass, and more preferably 0.5 parts by mass.

### Other Optional Components

The radiation-sensitive composition may contain in addition to the components (A) to (D), an acid generator, an acid diffusion controller, a fluorine atom-containing polymer and the like, for example, as other optional components. However, in a case in which the radiation-sensitive composition contains the base generator (C), the acid generator is typically not contained. The radiation-sensitive composition may contain one, or two or more types of each optional component.

### Acid Generator

The acid generator is a substance that generates an acid in a light-exposed region through an action by way of exposure light, etc. It is considered that due to containing the acid generator, the radiation-sensitive composition enables an increase in molecular weight of the metal oxide (A) in the light-exposed region by the acid, thereby consequently enabling the sensitivity of the radiation-sensitive composition to be more improved. The acid generator in the radiation-sensitive composition acid may be contained in the form of a low-molecular weight compound (hereinafter, may be also referred to as "acid generating agent" as appropriate) or in the form incorporated as a part of the metal oxide (A), etc., or may be in both of these forms.

The acid generating agent is exemplified by an onium salt compound, an N-sulfonyloxyimide compound, a halogen-containing compound, a diazo ketone compound, and the like.

Examples of the onium salt compound include a sulfonium salt, a tetrahydrothiophenium salt, an iodonium salt, a phosphonium salt, a diazonium salt, a pyridinium salt, and the like.

Specific examples of the acid generating agent include compounds disclosed in paragraphs [0080] to [0113] of Japanese Unexamined Patent Application, Publication No. 2009-134088, and the like.

In a case in which the radiation-sensitive composition contains the acid generating agent, the content of the acid generating agent with respect to 100 parts by mass of the metal oxide (A) may be, for example, no less than 0.1 parts by mass and no greater than 30 parts by mass.

### Acid Diffusion Controller

The acid diffusion controller controls a phenomenon of diffusion of the acid, which was generated from the acid generator, etc. upon the exposure, in the film, whereby the effect of inhibiting unwanted chemical reactions in an unexposed region is exhibited. In addition, the storage stability of the radiation-sensitive composition is more improved and the resolution thereof is improved. Moreover, in pattern formation conducted by using the radiation-sensitive composition, inhibition of variation of the line width of the pattern caused by variation of post-exposure time delay from the exposure until a development treatment, i.e., improvement of process stability is enabled. The acid diffusion controller may be contained in the radiation-sensitive composition in the form of a free compound (hereinafter, may be referred to as "acid diffusion control agent" as appropriate) or in the form incorporated as a part of the metal oxide (A), or may be in both of these forms.

The acid diffusion control agent is exemplified by a compound having one nitrogen atom in a single molecule, a compound having two nitrogen atoms in a single molecule, a compound having three nitrogen atoms, an amide group-containing compound, a urea compound, a nitrogen-containing heterocyclic compound, and the like. Alternatively, a photolabile base that generates a weak acid through photosensitization upon an exposure may be used as the acid diffusion control agent.

Specific examples of the acid diffusion control agent include compounds disclosed in paragraphs [0189] to [0197] of Japanese Unexamined Patent Application, Publication No. 2016-28274, and the like.

In a case in which the radiation-sensitive composition contains the acid diffusion control agent, the content of the acid diffusion control agent with respect to 100 parts by mass of the metal oxide (A) may be, for example, no less than 0.1 parts by mass and no greater than 20 parts by mass.

### Preparation Method of Radiation-Sensitive Composition

The radiation-sensitive composition may be prepared, for example, by mixing at a certain ratio, the metal oxide (A) and the solvent (B), as well as the optional component(s) that may be used as needed, such as the base generator (C) and the surfactant (D), preferably followed by filtering a thus obtained mixture through a membrane filter, etc. having a pore size of about 0.2 µm. The lower limit of the solid content concentration of the radiation-sensitive composition is preferably 0.1% by mass, more preferably 0.5% by mass, still more preferably 1% by mass, and particularly preferably 1.5% by mass. The upper limit of the solid content concentration is preferably 50% by mass, more preferably 30% by mass, still more preferably 10% by mass, and particularly preferably 5% by mass.

### Pattern-Forming Method

The pattern-forming method of the embodiment of the invention includes the steps of: applying the radiation-sensitive composition of the above embodiment directly or indirectly on a substrate to provide a film (hereinafter, may be also referred to as "applying step"); exposing the film (hereinafter, may be also referred to as "exposure step"); and developing the film exposed (hereinafter, may be also referred to as "development step"). Since the radiation-sensitive composition of the embodiment of the present invention is used, the pattern-forming method enables a pattern to be formed with superior sensitivity being achieved. Each step will be described below.

### Applying Step

In this step, the radiation-sensitive composition is applied directly or indirectly on a substrate to provide a film. In this step, the radiation-sensitive composition is typically applied directly or indirectly on one face side of the substrate. The application procedure is not particularly limited, and application means such as e.g., spin-coating, cast coating or roll coating may be employed. Specifically, after the radiation-sensitive composition of the embodiment is applied such that the resultant film has a predetermined thickness, prebaking (PB) is executed as needed to evaporate off the solvent (B) and the like in the film. The substrate is exemplified by a silicon wafer, a wafer coated with aluminum, and the like.

The lower limit of the average thickness of the film is preferably 1 nm, more preferably 10 nm, still more preferably 20 nm, and particularly preferably 30 nm. Meanwhile, the upper limit of the average thickness is preferably 1,000 nm, more preferably 200 nm, still more preferably 100 nm, and particularly preferably 70 nm.

The lower limit of the temperature of PB is preferably 60 °C, and more preferably 80 °C. Meanwhile, the upper limit of the temperature of PB is preferably 140 °C, and more preferably 120 °C. The lower limit of the time period of PB is preferably 5 sec, and more preferably 10 sec. Meanwhile, the upper limit of the time period of PB is preferably 600 sec, and more preferably 300 sec.

In the pattern-forming method, in order to maximize the potential ability of the radiation-sensitive composition of the present embodiment, for example, an organic or inorganic antireflective film may be formed beforehand on the substrate employed. In addition, in order to prevent influences of basic impurities etc., included in the environment atmosphere, a protective film may be also provided on the film formed in this step, for example. Furthermore, in a case where an exposure by way of liquid immersion is carried out in the exposure step, in order to avoid direct contact of the film with the liquid immersion medium, a protective film for liquid immersion may be also provided on the film formed in this step, for example.

### Exposure Step

In this step, the film described above is exposed. The exposure is carried out by irradiating with a radioactive ray through a mask having a predetermined pattern via a liquid immersion medium such as water, as the case may be. Examples of the radioactive ray include: electromagnetic waves such as a visible light ray, an ultraviolet ray, a far ultraviolet ray, a vacuum ultraviolet ray (EUV; wavelength: 13.5 nm), an X-ray and a γ-ray; charged particle rays such as an electron beam and an α-ray; and the like. Of these, radioactive rays are preferred which are likely to allow the metal-carbon covalent bond included in the metal oxide (A) to be cleaved upon the exposure, and specifically, EUV and an electron beam are preferred.

In this step, post exposure baking (PEB) may be carried out after the exposure. The lower limit of the temperature of PEB is preferably 50 °C, and more preferably 80 °C. Meanwhile, the upper limit of the temperature of PEB is preferably 180 °C, and more preferably 130 °C. The lower limit of the time period of PEB is preferably 5 sec, and more preferably 10 sec. Meanwhile, the upper limit of the time period of PEB is preferably 600 sec, and more preferably 300 sec.

### Development Step

In this step, the film exposed in the exposure step is developed. A developer solution for use in the development is exemplified by a developer solution containing an aqueous alkali solution or an organic solvent, and the like.

Examples of the aqueous alkali solution include alkaline aqueous solutions prepared by dissolving at least one of alkaline compounds such as sodium hydroxide, potassium hydroxide, sodium carbonate, sodium silicate, sodium metasilicate, aqueous ammonia, ethylamine, n-propylamine, diethylamine, di-n-propylamine, triethylamine, methyldiethylamine, ethyldimethylamine, triethanolamine, tetramethylammonium hydroxide (TMAH), pyrrole, piperidine, choline, 1,8-diazabicyclo-[5.4.0]-7-undecene and 1,5-diazabicyclo-[4.3.0]-5-nonene, and the like.

The lower limit of the content of the alkaline compound in the aqueous alkali solution is preferably 0.1% by mass, more preferably 0.5% by mass, and still more preferably 1% by mass. Meanwhile, the upper limit of the content is preferably 20% by mass, more preferably 10% by mass, and still more preferably 5% by mass.

The aqueous alkali solution is preferably an aqueous TMAH solution, and more preferably a 2.38% by mass aqueous TMAH solution.

Exemplary organic solvent in the developer solution containing the organic solvent includes those similar to the organic solvents exemplified for the solvent (B) of the radiation-sensitive composition, and the like. Of these, an ester solvent, an ether solvent, an alcohol solvent, a ketone solvent, an amide solvent, a hydrocarbon solvent or a combination thereof is preferably contained, and an ester solvent is more preferably contained. The developer solution is still more preferably a simple solvent of the ester solvent, and particularly preferably propylene glycol monomethyl ether acetate.

The lower limit of the content of the organic solvent in the developer solution containing the organic solvent is preferably 80% by mass, more preferably 90% by mass, still more preferably 95% by mass, and particularly preferably 99% by mass.

As the developer solution, the developer solution containing the organic solvent is preferred.

These developer solutions may be used either alone of one type, or two or more types thereof in combination. It is to be noted that the development is typically followed by washing with water, etc., and then drying.

A positive tone pattern can be obtained when the aqueous alkali solution is used as the developer solution. Whereas a negative tone pattern can be obtained when the developer solution containing the organic solvent is used as the developer solution.

### Metal Oxide

The metal oxide has a structural unit represented by the following formula (1). 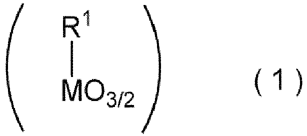 In the above formula (1), M represents germanium, tin or lead; R¹ represents a monovalent organic group having no greater than 30 carbon atoms which includes at least one of an electron attractive group and an unsaturated bond-containing group, and bonds to M via a carbon atom.

The metal oxide can be suitably used as a basic ingredient of the radiation-sensitive composition of the embodiment described above. Since details of the metal oxide have been described in the section "(A) Metal Oxide", the description thereof is omitted here.

### EXAMPLES

Hereinafter, the present invention is explained in detail by way of Examples, but the present invention is not in any way limited to these Examples.

### Synthesis of Metal Oxide

### Example 1

Into 100 g of a 0.5 M aqueous hydroxylated tetramethyl ammonium solution was placed 3.16 g of benzyltin trichloride, and the mixture was vigorously stirred at room temperature for 90 min. Thus separated precipitate was filtered out, and thereafter washed with 50 g of water twice to give a metal oxide (A-1) having a structural unit (I) represented by the following formula (X-1). The metal oxide (A-1) had Mw of 1,800. It is to be noted that Mw is a value determined by using gel permeation chromatography under the following conditions.

GPC columns: "G2000HXL" x 2, "G3000HXL" x 1 and "G4000HXL" x 1, available from Tosoh Corporation;
column temperature: 40 °C;
elution solvent: tetrahydrofuran;
flow rate: 1.0 mL/min;
sample concentration: 1.0% by mass;
amount of injected sample: 100 µL;
detector: differential refractometer; and
standard substance: mono-dispersed polystyrene

### Examples 2 to 6 and Comparative Examples 1 to 3

Metal oxides (A-2) to (A-6) of Examples 2 to 6 having the structural units (I) represented by the following formulae (X-2) to (X-6), respectively, and metal oxides (a-1) to (a-3) of Comparative Examples 1 to 3 having structural units represented by the following formulae (x-1) to (x-3), respectively were synthesized by a similar operation to that of Example 1 except that the monomer was changed adequately.

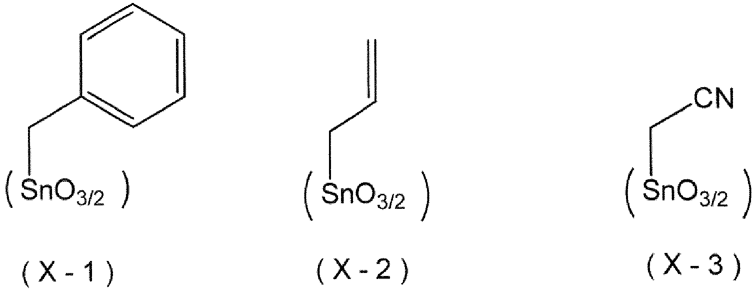

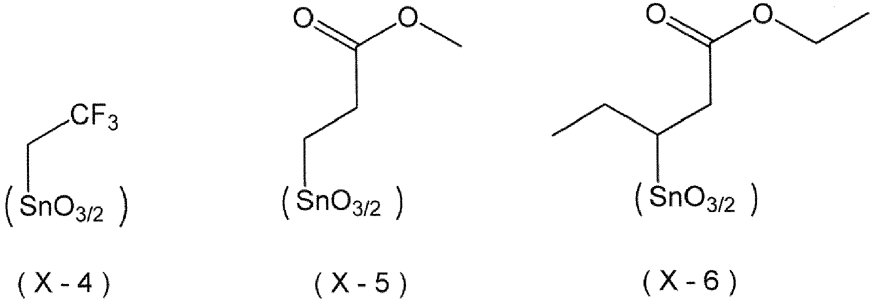

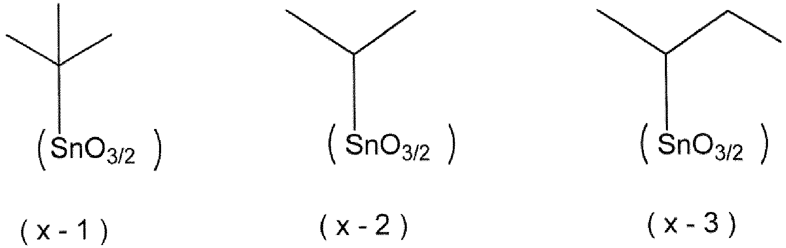

### Preparation of Radiation-Sensitive Composition

Components other than the metal oxide (A) used for preparing radiation-sensitive compositions are shown below.
(B) Solvent
   B-1: 4-methyl-2-pentanol
(C) Base Generator
   C-1: 2-nitrobenzylcyclohexyl carbamate
(D) Surfactant
   D-1: nonionic acetylene group-containing surfactant ("Surfinol 465", available from Nissin Chemical Co., Ltd.)

### Example 7

A radiation-sensitive composition (J-1) of Example 7 was prepared by mixing 3,000 parts by mass of the metal oxide (A-1) and 97,000 parts by mass of the solvent (B-1), and filtering a thus obtained mixture through a membrane filter having a pore size of 0.2 µm.

### Examples 8 to 14 and Comparative Examples 4 to 6

Radiation-sensitive compositions (J-2) to (J-8) of Examples 8 to 14 and radiation-sensitive compositions (j-1) to (j-3) of Comparative Examples 4 to 6 were prepared by a similar operation to that of Example 7 except that the type and the content of each component were as shown in Table 1 below. It is to be noted that the denotation "-" in Table 1 below indicates that a corresponding component was not used.

### Evaluation

Evaluation of sensitivity was made by using each radiation-sensitive composition of Examples and Comparative Examples through forming a pattern in accordance with the following method. The results of the evaluation are shown together in Table 1 below.

### Pattern-Forming Method

After each radiation-sensitive composition was spin-coated on a silicon wafer in CLEAN TRACK ACT-8 available from Tokyo Electron Limited, PB was carried out under a condition at 80 °C for 60 sec to form a film having an average thickness of 50 nm. Next, patterning was executed by irradiating the film with an electron beam using a simplified electron beam writer ("HL800D" available from Hitachi, Ltd., power: 50 KeV, electric current density: 5.0 ampere/cm²). After the irradiation with the electron beam, in the CLEAN TRACK ACT-8, propylene glycol monomethyl ether acetate was used to carry out a development in accordance with a puddle procedure at 23 °C for 1 min, followed by drying, whereby the pattern was formed.

### Sensitivity

The pattern was formed with varying exposure dose, whereby an exposure dose (optimum exposure dose) was decided at which formation of a line-and-space pattern (1L IS) with the line width of 1:1, configured with a line part having a line width of 150 nm and a space part having a width of 150 nm formed between neighboring line parts was enabled. The optimum exposure dose was defined as the sensitivity (µC/cm²) . The smaller sensitivity value indicates an evaluation result of being more favorable.

**Table 1**

| | Radiation-sensitive composition | (A) Metal oxide | | | (B) Solvent | | (C) Base generator | | (D) Surfactant | | Pattern formation | | Evaluation |
|---|---|---|---|---|---|---|---|---|---|---|---|---|---|
| | | type | Mw | parts by mass | type | parts by mass | type | parts by mass | type | parts by mass | developer solution | pattern tone | sensitivity (µC/cm²) |
| Example 7 | J-1 | A-1 | 1,800 | 3,000 | B-1 | 97,000 | - | - | - | - | PGMEA | negative | 20 |
| Example 8 | J-2 | A-2 | 2,000 | 3,000 | B-1 | 97,000 | - | - | - | - | PGMEA | negative | 21 |
| Example 9 | J-3 | A-3 | 1,900 | 3,000 | B-1 | 97,000 | - | - | - | - | PGMEA | negative | 28 |
| Example 10 | J-4 | A-4 | 2,100 | 3,000 | B-1 | 97,000 | - | - | - | - | PGMEA | negative | 27 |
| Example 11 | J-5 | A-5 | 1,800 | 3,000 | B-1 | 97,000 | - | - | - | - | PGMEA | negative | 30 |
| Example 12 | J-6 | A-6 | 2,000 | 3,000 | B-1 | 97,000 | - | - | - | - | PGMEA | negative | 25 |
| Example 13 | J-7 | A-1 | 1,900 | 2,910 | B-1 | 97,000 | C-1 | 0.090 | - | - | PGMEA | negative | 18 |
| Example 14 | J-8 | A-1 | 2,000 | 2,909 | B-1 | 97,000 | C-1 | 0.090 | D-1 | 0.001 | PGMEA | negative | 18 |
| Comparative Example 4 | j-1 | a-1 | 2,000 | 3,000 | B-1 | 97,000 | - | - | - | - | PGMEA | negative | 35 |
| Comparative Example 5 | j-2 | a-2 | 1,800 | 3,000 | B-1 | 97,000 | - | - | - | - | PGMEA | negative | 40 |
| Comparative Example 6 | j-3 | a-3 | 1,900 | 3,000 | B-1 | 97,000 | - | - | - | - | PGMEA | negative | 37 |

As is seen from the results shown in Table 1 above, the radiation-sensitive compositions of Examples were more favorable in sensitivity than the radiation-sensitive compositions of Comparative Examples.

### [INDUSTRIAL APPLICABILITY]

The radiation-sensitive composition and the pattern-forming method of the embodiments of the present invention enable a pattern to be formed with superior sensitivity being achieved. The metal oxide of the embodiment of the present invention can be suitably used as a source material of the radiation-sensitive composition of the one embodiment of the invention. Therefore, these can be suitably used in manufacture of semiconductor devices in which further progress of miniaturization is expected in the future.

## Claims

1. A radiation-sensitive composition comprising:
a metal oxide comprising a structural unit represented by formula (1); and
a solvent, 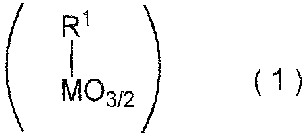
wherein, in the formula (1),
M represents germanium, tin or lead; and
R¹ represents a monovalent organic group having no greater than 30 carbon atoms which comprises at least one of an electron attractive group and an unsaturated bond-containing group, and bonds to M via a carbon atom.

2. The radiation-sensitive composition according to claim 1, wherein
the monovalent organic group represented by R¹ comprises the unsaturated bond-containing group, and
the unsaturated bond-containing group is at least one of an aromatic group and an ethylenic double bond-containing group.

3. The radiation-sensitive composition according to claim 1 or 2, wherein
the monovalent organic group represented by R¹ comprises an electron attractive group, and
the electron attractive group is at least one of a cyano group, a nitro group, a halogenated alkyl group, -COO-, and a cationic group.

4. The radiation-sensitive composition according to any one of claims 1 to 3, wherein the structural unit is represented by formula (1-1): 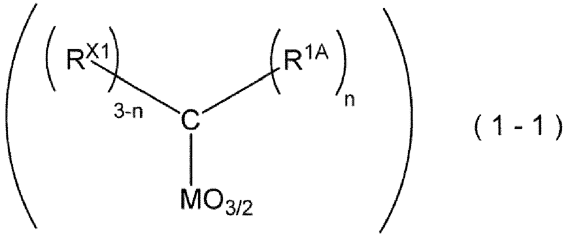
wherein, in the formula (1-1),
M is as defined in the formula (1);
R^{1A} represents: a first substituent that is a monovalent organic group having 2 to 29 carbon atoms which comprises an unsaturated bond-containing group, and bonds to the carbon atom bonding to M via one of carbon atoms constituting the unsaturated bond; a second substituent that is a monovalent organic group having 1 to 29 carbon atoms which comprises a divalent electron attractive group, and bonds to the carbon atom bonding to M via the divalent electron attractive group; or a monovalent electron attractive group;
R^{X1} represents a hydrogen atom, or an alkyl group having 1 to 5 carbon atoms; and
n is an integer of 1 to 3,
wherein
in a case in which there exist a plurality of R^{1A}s, the plurality of R^{1A}s are identical or different, and
in a case in which there exist a plurality of R^{X1}S, the plurality of R^{X1}s are identical or different.

5. The radiation-sensitive composition according to any one of claims 1 to 4, wherein a content of the metal oxide in terms of solid content equivalent is no less than 50% by mass.

6. The radiation-sensitive composition according to any one of claims 1 to 5, wherein the solvent is an organic solvent.

7. The radiation-sensitive composition according to claim 6, wherein the organic solvent comprises an alcohol solvent having 1 to 10 carbon atoms.

8. A pattern-forming method comprising:
applying the radiation-sensitive composition according to any one of claims 1 to 7 directly or indirectly on a substrate to provide a film;
exposing the film; and
developing the film exposed.

9. The pattern-forming method according to claim 8, wherein a developer solution used in the developing comprises an organic solvent.

10. The pattern-forming method according to claim 8 or 9, wherein a radioactive ray used in the exposing is an extreme ultraviolet ray or an electron beam.

11. A metal oxide comprising a structural unit represented by formula (1): 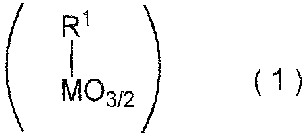
wherein, in the formula (1),
M represents germanium, tin or lead; and
R¹ represents a monovalent organic group having no greater than 30 carbon atoms which comprises at least one of an electron attractive group and an unsaturated bond-containing group, and bonds to M via a carbon atom.
